Europäisches Patentamt

European Patent Office

Office européen des brevets

(11) Publication number: 0 471 376 A2

# EUROPEAN PATENT APPLICATION

(21) Application number: 91113779.2

(22) Date of filing: 16.08.91

(51) Int. Cl.5: H01L 23/522

(30) Priority: 16.08.90 JP 214936/90

(43) Date of publication of application:
19.02.92 Bulletin 92/08

(84) Designated Contracting States:
DE FR GB

(71) Applicant: Kabushiki Kaisha Toshiba
72, Horikawa-cho Saiwai-ku
Kawasaki-shi(JP)

(72) Inventor: Kitahara, Koichi, c/o Intellectual
Property Div.
1-1 Shibaura 1-chome, Minato-ku
Tokyo 105(JP)
Inventor: Takagi, Yosuke, c/o Intellectual
Property Div.
1-1 Shibaura 1-chome, Minato-ku
Tokyo 105(JP)
Inventor: Ohata, Yu, c/o Intellectual Property
Div.
1-1 Shibaura 1-chome, Minato-ku
Tokyo 105(JP)

(74) Representative: Lehn, Werner, Dipl.-Ing. et al
Hoffmann, Eitle & Partner Patentanwälte
Arabellastrasse 4
W-8000 München 81(DE)

(54) Electrode structure of monolithically-formed heavy-current element and small signal element and method of manufacturing the same.

(57) The semiconductors according to the present invention have a structure in which a heavy-current element and a small signal element are formed on a semiconductor substrate (11). The electrode of the small signal element is formed from an aluminum film (19), whereas that of the heavy-current element is formed from aluminum film (19), titanium film (24), and aluminum film (25). Thus, the thickness of the heavy-current element is thicker than that of the small signal element by the total thickness of the titanium film (24) and the aluminum film (25). With this structure, the current capacity of the device can be increased by thickening the electrode of the heavy-current element, and the degree of integration of the device can be enhanced by thinning the electrode of the small signal element, without employing a multi-layer wiring technique.

FIG. 2

EP 0 471 376 A2

The present invention relates to an electrode structure of a heavy-current element and a control-use small signal element, which are formed monolithically, and is designed to enhance the capacitance of the heavy-current element and the degree of integration of the control-use small signal element at the same time.

In a conventional semiconductor device having monolithically formed heavy-current element and control-use small signal element, the current capacitance of the element is proportional to the thickness of the electrode (Aℓ) of the heavy-current element. In other words, the current capacitance increases as the electrode of the element is thickened.

Since the electrode (Aℓ) of the small signal element is formed along with that of the heavy-current electrode, the electrode of the small signal element thus formed has, though it does not have to be that thick, the same thickness as that of the heavy-current electrode. Therefore, it takes more side etching in order to carried out patterning of the electrode of the small signal element, than it is required in the case where the small signal element is made separately.

Therefore, to carry out a successful etching, the width of the electrode on a resist serving as a mask is made thicker than usual. Such a thick electrode of the small signal element obstructs the enhancement of the integration degree of the small signal element.

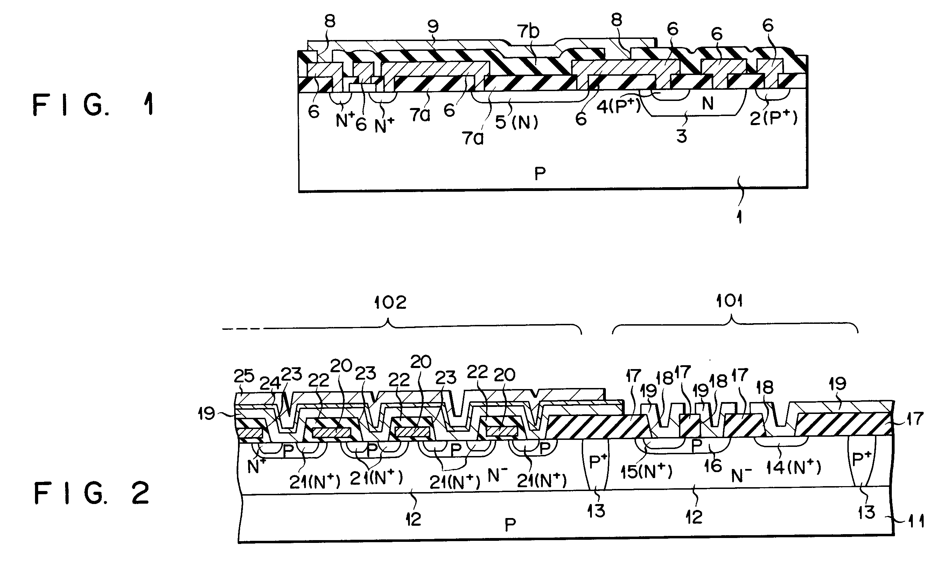

Fig. 1 shows a structure of an electrode (Aℓ-double-layered structure) formed by a multi-layer wiring technique as an example of those of the heavy-current element and the control-use small signal element which are monolithically formed. A multi-layer wiring technique is often employed for manufacturing large scale integrated circuits. However, with this technique, there must be provided an insulating film between the first and second electrodes; therefore the number of forming steps is increased, and the cost of product will be higher. In Fig. 1, sketched are a P-type semiconductor substrate 1, a P$^+$-type collector region, an N-type base region 3, a P$^+$-type emitter region, a diffusion resistance 5, a first layer electrode 6, insulating films 7a and 7b, a through hole 8, and a second layer electrode 9.

The present invention has been proposed to solve the above-described problems, and the purpose thereof is to increase the current capacity by thickening the electrode of the heavy-current element, and enhance the degree of integration of the IC by thinning the electrode of the small signal element, without employing a multi-layer wiring technique.

In order to achieve the above purpose, the semiconductor according to the present invention includes a heavy-current element and a small signal element. An electrode of the small signal element is formed from the first conductive film having one or more layers, whereas that of the heavy-current element is formed from the first conductive film and the second conductive film having two or more layers, which is formed on the first conductive film.

A method of forming the electrodes according to the present invention is as follows:

The first conductive film having one or more layers is formed on the heavy-current element and the small signal element, and then the second conductive film having two or more layers is formed on the first conductive film. Thereafter, the second conductive film and the underlying first conductive film are etched, so as to make the first electrode of the small signal element formed from the first conductive film, and the second electrode of the heavy-current element, formed from the first and second conductive film.

This invention can be more fully understood from the following detailed description when taken in conjunction with the accompanying drawings, in which:

Fig. 1 is a cross section of a conventional semiconductor device;

Fig. 2 is a cross section of a semiconductor device according to an embodiment of the present invention;

Figs. 3A to 3E are cross sections of the semiconductor device shown in Fig. 2 at stages of a method of manufacturing thereof;

Figs. 4A to 4C are cross sections of the semiconductor device shown in Fig. 2 at stages of another method of manufacturing thereof; and

Figs. 5 to 8 are cross sections of semiconductors according to the other embodiments of the present invention.

An embodiment of the present invention will now be explained in detail with reference to accompanying drawings. It should be noted here that common structural elements are designated by the same reference numerals throughout all the drawings.

Fig. 2 is a cross section of a semiconductor device according to an embodiment of the present invention.

As shown in this figure, an N$^-$-type semiconductor region 12 is formed on an p-type semiconductor substrate 11. This N$^-$-type semiconductor region 12 is formed by, for example, an epitaxial growth method. In the N$^-$-type semiconductor region 12, formed are a P$^+$-type diffusion region 13 which runs from the surface of the region 13 up through the P-type semiconductor substrate 11. The N$^-$-type semiconductor region 12 is divided into a plurality of sections by the P-type semiconductor substrate 11 and a $P^+$-type diffusion region 13. One of the sections will give rise to a small signal element portion 101, and another to a heavy-current element portion 102.

In the small signal element portion 101, there is formed an element for allowing a small current to flow therethrough such as an NPN-type transistor. The NPN-type transistor includes an $N^+$-type collector region 14, an $N^+$-type emitter region 15, and a P-type base region 16. Further, an insulating film 17 is formed on the NPN-type transistor. The insulating film 17 has contact holes 18 running through to the $N^+$-type collector region 14, the $N^+$-type emitter region 15, and the P-type base region 16, respectively. In each of the contact holes 18, an Aluminum film 19, which serves as an electrode of the small signal element, is formed.

The heavy-current element portion 102 has a power element for allowing a large current to flow therethrough such as a D-MOS type FET formed therein. The D-MOS type FET includes a gate electrode 20, an $N^-$-type source region 21, and an $N^-$-type semiconductor region (drain region) 12. Further, an insulating film 22 is formed on the D-MOS type FET. This insulating film 22 has contact holes 23, and the portions of the film 22 and the holes 23 which are exposed, are all-throughout covered by an aluminum film 19. On the aluminum film 19, formed is a titanium film 24, on which an aluminum film 25 is also formed. The aluminum film 19, the titanium film 24, and the aluminum film 25 constitute the electrode of the heavy-current element. It should be noted here that the etching speed in the case where an acidic solution is used or in the case of dry etching where a reaction gas is used, is lower for the titanium film 24 than the aluminum film 25.

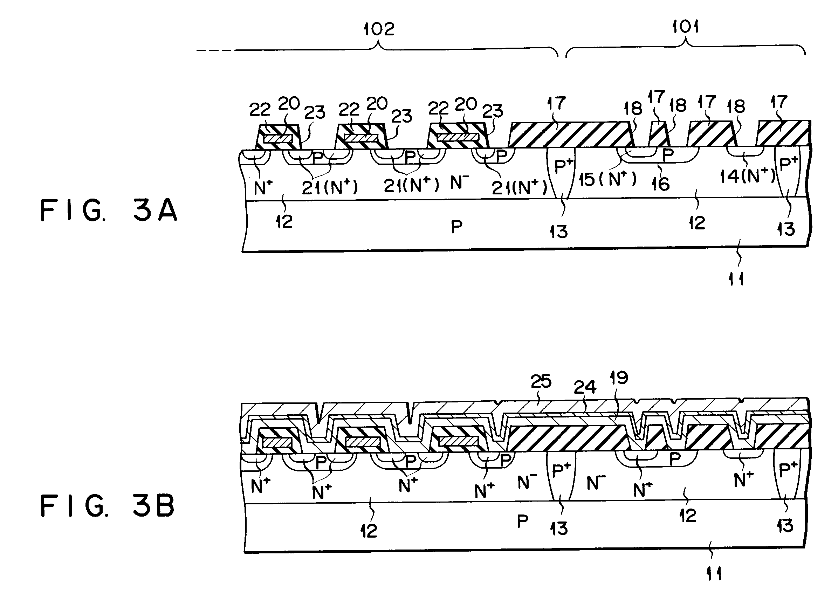

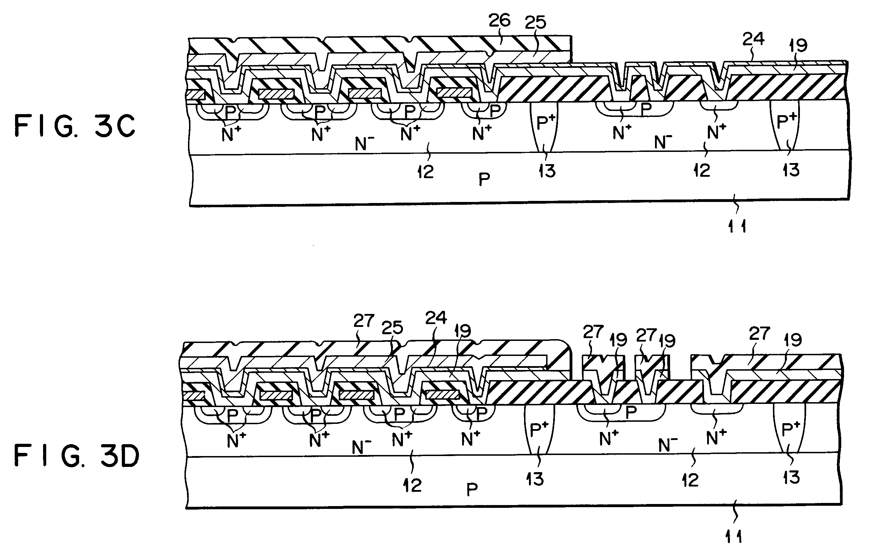

Figs. 3A to 3E illustrates a method of manufacturing the semiconductor device shown in Fig. 2.

The manufacture according to this method starts with the procedure as shown in Fig. 3A. In this procedure, the $N^-$-type semiconductor region 12 is formed on the P-type semiconductor substrate 11 by an epitaxial growth method, and in the $N^-$-type semiconductor region 12, formed is the P-type diffusion region 13 which runs from the surface of the semiconductor region 12 through to the P-type semiconductor substrate 11. Thus, the $N^-$-type semiconductor region 12 is divided into a plurality of sections by the P-type semiconductor substrate 11 and the $P^+$-type diffusion region 13. Then, a small signal element, for example, an NPN-type transistor, is formed on one of the sections (that one giving rise to the small signal element portion 101). The NPN-type transistor includes the $N^+$-type collector region 14, the $N^+$-type emitter region 15, and the P-type base region 16. Further, a heavy-current element, for example, a D-MOS type FET, is formed on another one of the sections (that giving rise to the heavy-current element portion 102). The D-MOS type FET includes the gate electrode 20, the $N^-$-type source region 21, and the $N^-$-type semiconductor region (drain region) 12. Thereafter, the insulating films 17 and 22 are formed on the small signal element portion 101 and the heavy-current element 102, respectively, followed by formation of contact holes 18 and 23 on these insulating films 17 and 22.

Fig. 3B shows the next procedure of the manufacturing method. In this procedure, the aluminum film 19 having the thickness of about 1 $\mu$m is formed on the entire surface of the substrate 11, and then the titanium film having the thickness of about 0.15 $\mu$m is formed on this A$\ell$ film 19. Further, the aluminum film 25 having the thickness of about 3 $\mu$m is formed on this titanium film 24.

Fig. 3C shows the next procedure of the manufacturing method. In this procedure, a photoresist 26, which is to serve as a mask therefor, is formed on the aluminum film 25, and this film 25 is etched by an acidic solution (for example, phosphericacid-containing solution). Thus, the portion of the aluminum film 25, which covers the small signal element portion 101, is removed. It should be noted that the aluminum film 25 may be etched by the reactive ion etching technique (RIE) using a reaction gas. Further, since the etching of the aluminum film 25 is stopped by the titanium film 24, the aluminum film 19 is not etched. This is because the etching speed for the titanium film 24 with regard to the acidic solution is much slower than that for the aluminum film 25 (Ti 24 $\ll$ A$\ell$ 25).

Next, as can be seem in Fig. 3D, the exposed portion of the titanium film 24 is removed by an etching technique with the use of, for example, an ethylenediaminetetraacetic acid solution. Then, a photoresist 27 having a pattern with which an electrode is formed, is formed on the aluminum films 19 and 25. Thereafter, the aluminum film 19, masked by the photoresist 27, is etched by an acidic solution (for example, solution containing phosphoric acid). Thus, an electrode formed from the aluminum film 19 is made in the small signal element portion, and an electrode formed from the aluminum film 19, titanium film 24, and aluminum film 25, is made in the heavy-current element portion 102. It should be noted that the aluminum film 19 may be etched by the RIE technique using a reaction gas.

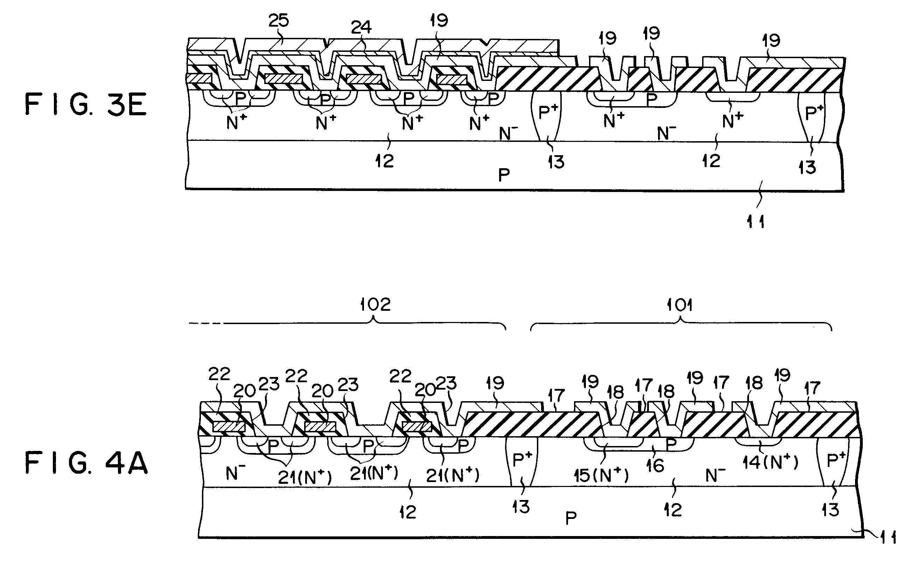

Lastly, as shown in Fig. 3E, the photoresist 27 is removed, and thus completed is a monolithic semiconductor device including the small signal element portion 101 and the heavy-current element portion 102, the electrodes of which have thicknesses different from each other.

As described above, the electrode of the small signal element is formed from the aluminum film 19, and that of the heavy-current element is formed from the aluminum film 19, titanium film 24, and aluminum film 25; therefore the electrode of the heavy-current element portion 102 is thicker than that of the small signal element by the thickness of the titanium film 24 and the aluminum film 25. With this structure, the degree of the side etching for forming the electrode of the small signal element portion 101 can be decreased, and a wiring pattern on the mask used for etching can be made finer than usual. Incidentally, with conventional methods, a dry etching technique was not suitable to be employed due to the facts that much time is required until completion of the etching, and that the etching selection ratio of the mask material to aluminum, is small, etc. However, in the present invention, the thickness of the electrode of the small signal element is as thin as 1 $\mu$m; therefore the dry etching can be also employed. Further, resists having high resolution degree and low adhesion can be used in the invention; therefore the small signal element portion 101 can be further integrated.

Figs. 4A to 4C illustrate another method of manufacturing the semiconductor device shown in Fig. 2.

As shown in Fig. 4A, the procedure of this method starts with formation of, for example, an NPN-type transistor in the small signal element portion 101, followed by formation of, for example, a D-MOS type FET in the heavy-current element portion 102. The NPN-type transistor includes the N$^+$-type collector region 14, the N$^+$-type emitter region 15, and the P-type base region 16, and the D-MOS type FET includes the gate electrode 20, the N$^+$-type source region 21, and the N$^-$-type semiconductor region (drain region) 12, etc. Then, the insulating films 17 and 22 are formed in the small signal element portion 101 and the heavy-current element portion 102. Thereafter, the contact holes 18 and 23 are made in the insulating films 17 and 23, and the aluminum film 19 having the thickness of about 1 $\mu$m is formed on these insulating films 17 and 22. Then, a photoresist is formed on the aluminum film 19 so as to serve as a mask for this aluminum film 19, and the film 19 is etched by an acidic solution (for example, phosphoric-acid-containing solution), thereby forming an aluminum-film-made electrode of the small signal element portion 101. It should be noted that the aluminum film 19 may be etched by the RIE technique using a reaction gas.

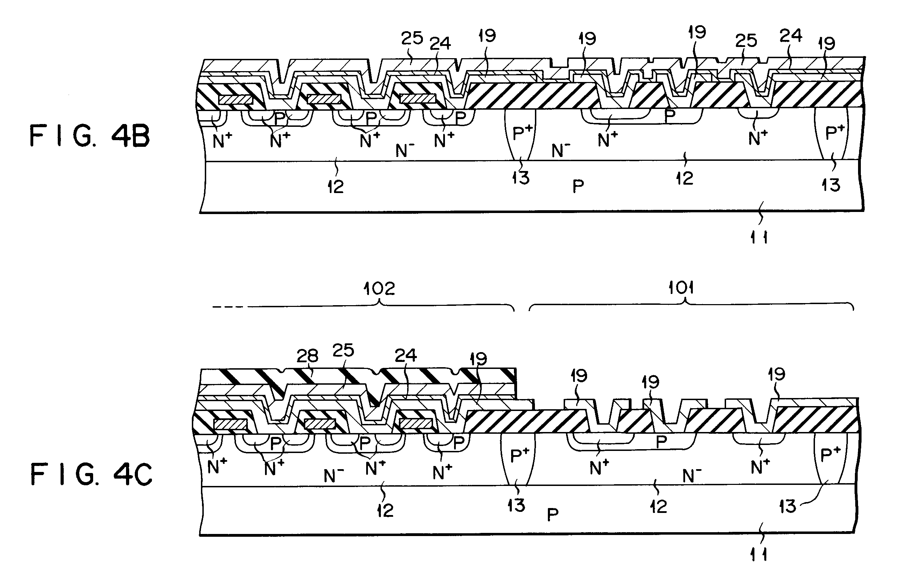

Next, as can be seen in Fig. 4B, the titanium film 24 having the thickness of about 0.15 $\mu$m is formed on the entire surface of the substrate 11, and on the titanium film 24, formed is the aluminum film 25 having the thickness of about 3 $\mu$m.

As shown in Fig. 4C, the next procedure starts with formation of a photoresist 28 on the aluminum film 25. With the photoresist 28 serving as a mask, the aluminum film 25 of the small signal element portion 101 is etched by an acidic solution (for example, phosphoric-acid-containing solution), or by the RIE technique using a reaction gas. While etching the film 25, the aluminum film 19 is not etched due to a difference in etching speed as for Ti and A$\ell$ (Ti $\ll$ A$\ell$). Then, the portion of the titanium film 24 which is exposed is etched by, for example, an ethlenediaminetetraacetic acid solution.

The last stage, which is not shown in the figure, proceeds as follows:

The photoresist 28 is removed, and finished is the making of the electrode of the small signal element formed from the aluminum film 19 in the small signal element portion 101, and the electrode of the heavy-current element formed from the aluminum film 19, titanium film 24, and aluminum film 25 in the small signal element portion 102. Thus, the monolithic semiconductor device including the small signal element portion 101 and the heavy-current element portion 102 the electrodes of which have thicknesses different from each other.

With the above-explained method, the electrode of the small signal element, which is formed of the aluminum film 19, and the electrode of the heavy-current element, which is formed from the aluminum film 19, titanium film 24, and aluminum film 25, can be made with a structure in which the electrode of the heavy-current element portion 102 is thicker than that of the small signal element portion 101 by the thickness of the titanium film 24 and aluminum film 25.

It should be noted here that the semiconductor of the present invention is not limited to that shown in Fig. 2, but can be remodeled into a variety of versions.

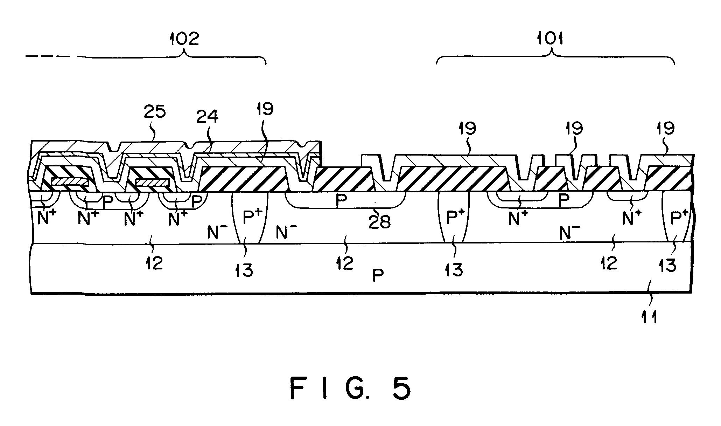

Fig. 5 shows another semiconductor device in which a diffusion resistance 28 is formed in one of a plurality of N$^-$-type semiconductor region 12. To one end of a diffusion resistance, an electrode of a small signal element, which is formed from an aluminum film 19, is connected, whereas to the other end, an electrode of a large-current element, which is formed of the aluminum film 19, titanium 24, and aluminum film 25, is connected. In this semiconductor device, an active element such as an NPN-type transistor, etc., or a polysilicon resistance can be formed in place of the diffusion resistance 28.

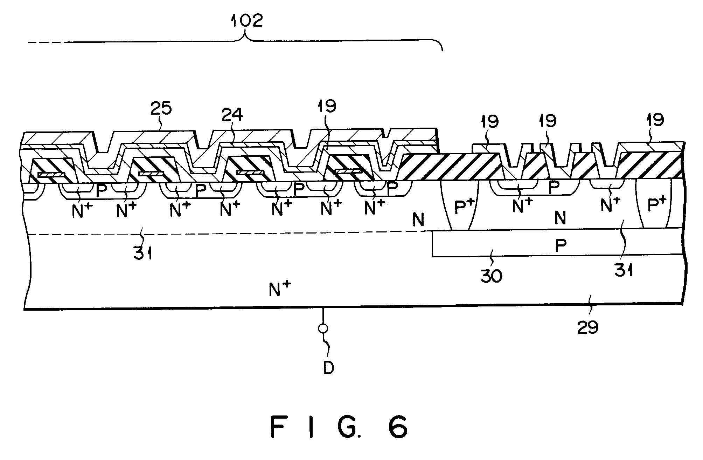

Fig. 6 shows another semiconductor device in which a vertical type D-MOS FET is formed in a heavy-current element portion 102. In this figure, depicted are an N$^+$-type semiconductor substrate 29, a P-type embedded region 30, and an N-type semiconductor region (drain region) 31. With this structure, a drain electrode D of the heavy-current element portion 102 is located on the outer bottom surface side of a substrate; therefore a large output current can be obtained.

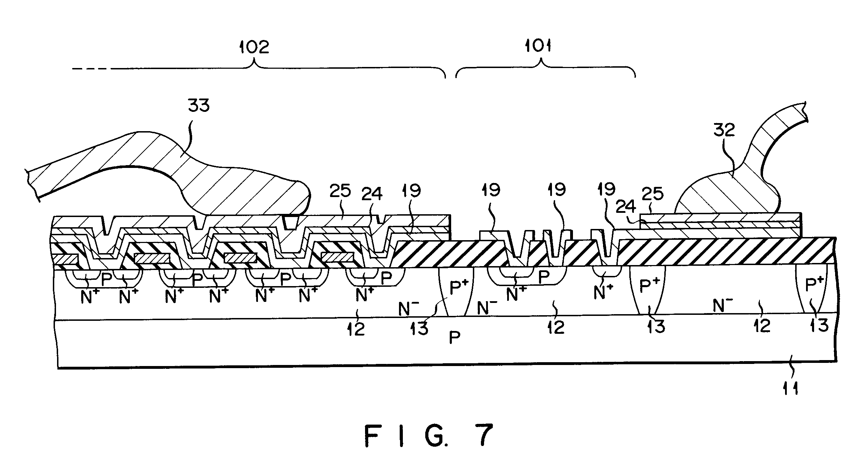

Fig. 7 shows another embodiment of the present invention, in which an electrode of an small signal element is formed from an aluminum film 19, and an bonding pad of the small signal element is formed of the aluminum film 19, titanium film 24, and aluminum film 25. In a heavy-current element portion 102, the bonding pad is formed from the aluminum film 19, titanium film 24, and aluminum film 25. Since an Au wire 32, for example, is bonded onto the small signal element 101, whereas an Aℓ wire 33, for example, is bonded onto the heavy-current element portion 102, thereby protecting the items located underneath the bonding pads.

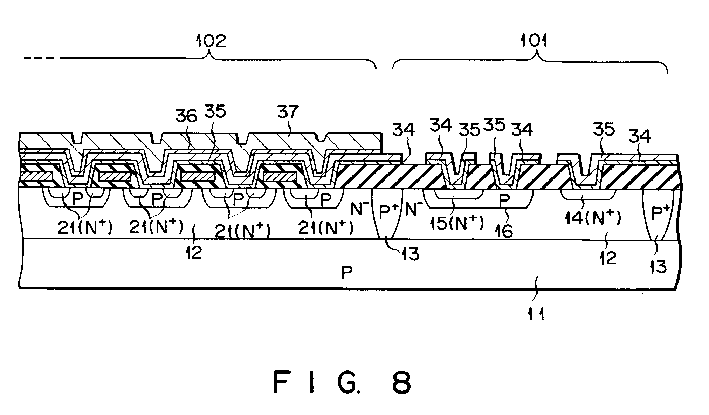

Fig. 8 shows a semiconductor device according to another embodiment of the present invention.

In a small signal element portion 101, formed are an $N^+$-type collector region 14, an $N^+$-type emitter region 15, an NPN-type transistor having a P-type base region 16. Further, an electrode of the small signal element, which is formed from a titanium film 34 and aluminum film 35, is made to locate on this transistor. Meanwhile, a heavy-current element portion 102 includes a gate electrode 20, an $N^+$-type source region 21, a D-MOS type FET having an $N^-$-type semiconductor region (drain region) 12. Similarly, an electrode of the heavy-current element, which is formed from a titanium film 34, aluminum film 35, titanium film 36, and aluminum film 37, is made to locate on this D-MOS type FET.

As described above, the electrode of the small signal element is formed from the titanium film 34 and the aluminum film 35, and the electrode of the heavy-current element is formed from the titanium film 34, aluminum film 35, titanium film 36, and aluminum film 37. Thus, the electrode of the heavy-current element portion 102 is thicker than that of the small signal element portion 101 by the total thickness of the titanium film 36 and the aluminum film 37. Consequently, the semiconductor device thus made exhibits the same characteristics as that shown in Fig. 2. It should be noted that the titanium film 34 serves as a barrier metal which prevents a heat reaction between the aluminum film 35 and the substrate (the $N^+$-type collector region 14, etc.) during a sintering process.

Incidentally, throughout the embodiments described above, the electrode of each of the small signal elements is single-layered (aluminum film 19) or double-layered (titanium film 34 and aluminum film 19), but it can be formed from more than two layers. Similarly, the electrode of each of the heavy-current elements is triple-layered (aluminum film 19, titanium film 24, and aluminum film 25) or quadruple-layered (titanium film 34, aluminum film 19, titanium 24, and aluminum film 25), but it can be formed from more than four layers. The electrode of each of the heavy-current element includes, as a part thereof, the same structure as the electrode of the corresponding small signal element.

In addition, the material for electrodes of both heavy-current element and small signal element does not have to be a pure aluminum film, but can be an Aℓ-Sifilm, or Aℓ-Si-Cu film. Further, a heavy-current element is not limited to a D-MOS FET, but can be, for example, a bipolar transistor or an IGBT.

## Claims

1. A semiconductor device characterized by comprising:

a semiconductor substrate; and

a small signal element and a heavy-current element formed on said semiconductor substrate, said small signal element having an electrode formed from a first conductive film containing one or more layers, and said heavy-current element having an electrode formed from said first conductive film, and a second conductive film, located on said first conductive film, containing two or more layers.

2. A semiconductor device according to claim 1, characterized by further comprising a bonding pad formed from said first conductive film and said second conductive film, located thereon, containing two or more layers.

3. A semiconductor device according to claim 1, characterized in that said first conductive film is aluminum.

4. A semiconductor device according to claim 1, characterized in that said first conductive film is formed from a titanium film and an aluminum formed thereon.

5. A semiconductor device according to claim 1, characterized in that said second conductive film is formed from a titanium film and an aluminum formed thereon.

6. A method of forming electrodes of a heavy-current element and a small signal element which are monolithically formed characterized by comprising:

a first step of forming a first conductive film containing one or more layers on said heavy-current element and said small signal element;

a second step of forming a second conductive film containing two or more layers on said first conductive film; and

a third step of etching said second conductive film and said first conductive film so as to make the electrode of said small signal element formed from said first conductive film, and the electrode of said heavy-current element of said first and second films.

7. A method of forming the electrodes according to claim 6, characterized in that said first step consists of forming an aluminum film on said heavy-current element and said small signal element.

8. A method of forming the electrodes according to claim 6, characterized in that said first step consists of forming a titanium film on said heavy-current element and said small signal element, and forming an aluminum film on said titanium film.

9. A method of forming the electrodes according to claim 6, characterized in that said second step consists of forming a titanium film on said first conductive film, and forming an aluminum film on said titanium film.

10. A method of forming the electrodes according to claim 6, characterized in that said third step includes etching of said second conductive film and said first conductive film so as to make a bonding pad of said small signal element formed from said first conductive film, and a bonding pad of said heavy-current element of said first and second films.

11. A method of forming electrodes of a heavy-current element and a small signal element which are monolithically formed, characterized by comprising:

a first step of forming a first conductive film having one or more layers, on said heavy-current element and said small signal element;

a second step of etching said first conductive film to form the electrode of said small signal element made of said first conductive film;

a third step of forming a second conductive film having two or more layers, on said first conductive film; and

a fourth step of etching said second conductive film to form the electrode of said heavy-current element formed from said first and second conductive films.

12. A method of forming the electrodes according to claim 11, characterized in that said first step consists of forming an aluminum film on said heavy-current element and said small signal element.

13. A method of forming the electrodes according to claim 11, characterized in that said first step includes forming of a titanium film on said heavy-current element and said small signal element, and forming of an aluminum film on said titanium film.

EP 0 471 376 A2

FIG. 1

8　9　7b　8　6　6　6

6　N⁺ 6 N⁺　7a　6　5(N)　6　4(P⁺)　N　2(P⁺)
7a　3

P

1

102　　　　　　　101

25 24 23 22 20 23 22 20 23 22 20　　17 18 17 18 17 18　19

19　　　　　　　　　　　　　　　　19 19 19　　　　　　　17

N⁺　21(N⁺) 21(N⁺)　21(N⁺) N⁻ 21(N⁺)　P⁺　15(N⁺)　16　N⁻　14(N⁺)　P⁺

12　P　13　12　13　11

FIG. 2

FIG. 3A

FIG. 3B

FIG. 3C

FIG. 3D

FIG. 3E

FIG. 4A

F I G. 4B

F I G. 4C

F I G. 5

F I G. 6

F I G. 7

FIG. 8

EP 0 471 376 A2